# EUROPEAN PATENT APPLICATION

(11) **EP 3 575 872 A1**
(43) Date of publication of application: **04.12.2019**
(21) Application number: 17894565.5
(22) Date of filing: 18.12.2017
(51) Int. Cl.: G03F 7/038, G03F 7/004

(54) **RADIATION-SENSITIVE COMPOSITION AND PATTERN FORMATION METHOD**

(30) Priority: 26.01.2017 JP 2017012181
(71) Applicant: JSR Corporation, Minato-ku Tokyo 105-8640 (JP)
(72) Inventor: MINEGISHI Shinya, Tokyo 105-8640 (JP); SHIRATANI Motohiro, Tokyo 105-8640 (JP); NAKAGAWA Hisashi, Tokyo 105-8640 (JP)
(74) Representative: TBK
(86) International application number: PCT/JP2017/045386
(87) International publication number: WO 2018/139109

(57) **Abstract**

A radiation-sensitive composition contains: a metal oxide having a first structural unit represented by the following formula (1), the following formula (2) or a combination thereof, and a second structural unit represented by the following formula (3); and a solvent. In the following formulae (1) to (3), Ms each independently represent germanium, tin or lead; and R¹, R² and R³ each independently represent a monovalent organic group having 1 to 40 carbon atoms which bonds to M via a carbon atom. A proportion of the first structural unit contained with respect to total structural units constituting the metal oxide is preferably no less than 50 mol%.

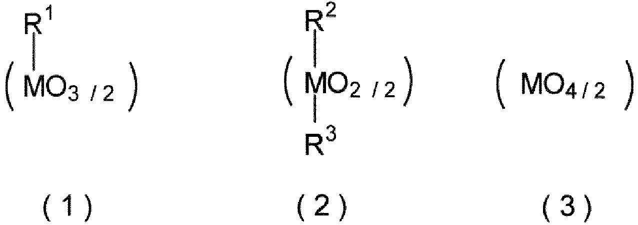

## Description

### [Technical Field]

The present invention relates to a radiation-sensitive composition and a pattern-forming method.

### [Background Art]

A radiation-sensitive composition for use in microfabrication by lithography generates an acid at a light-exposed region upon an exposure with an electromagnetic wave such as a far ultraviolet ray (ArF excimer laser beam, KrF excimer laser beam, etc.) or an extreme ultraviolet ray (EUV: Extreme Ultraviolet), a charged particle ray such as an electron beam. A chemical reaction in which the acid serves as a catalyst causes the difference in rates of dissolution in a developer solution, between light-exposed regions and light-unexposed regions to enable a resist pattern to be formed on a substrate.

Such radiation-sensitive compositions are demanded to have improved resist performances along with miniaturization in processing techniques. To meet such demands, types, molecular structures and the like of polymers, acid generating agents and other components which may be used in the compositions have been investigated, and combinations thereof have been further investigated in detail (see, Japanese Unexamined

Patent Application, Publication Nos. H11-125907, H8-146610 and 2000-298347).

### [Prior Art Documents]

### [Patent Documents]

Patent Document 1: Japanese Unexamined Patent Application, Publication No. H11-125907
Patent Document 2: Japanese Unexamined Patent Application, Publication No. H8-146610
Patent Document 3: Japanese Unexamined Patent Application, Publication No. 2000-298347

### [SUMMARY OF THE INVENTION]

### [Problems to be Solved by the Invention]

At present, miniaturization of patterns has proceeded to a level for line widths of no greater than 40 nm, whereby radiation-sensitive compositions are needed to have various resist performances being further improved, and to be capable of achieving high sensitivity also in cases of exposure with an electron beam, EUV and the like, in particular. In addition, there also exist a demand for further improving etching resistance of the pattern to be formed. However, the conventional radiation-sensitive compositions have not satisfied the needs.

The present invention was made in view of the foregoing circumstances, and an object of the invention is to provide a radiation-sensitive composition being superior in sensitivity as well as being capable of forming a pattern superior in etching resistance.

### [Means for Solving the Problems]

According to one aspect of the invention made for solving the aforementioned problems, a radiation-sensitive composition contains: a metal oxide having a first structural unit represented by the following formula (1), the following formula (2) or a combination thereof, and a second structural unit represented by the following formula (3); and a solvent. 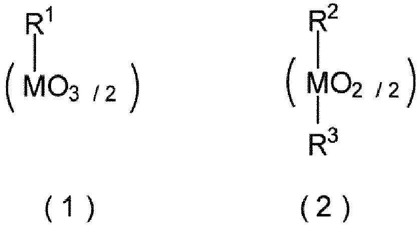 wherein, in the formulae (1) and (2), Ms each independently represent germanium, tin or lead; and R¹, R² and R³ each independently represent a monovalent organic group having 1 to 40 carbon atoms which bonds to M via a carbon atom.

(MO_{4/2}) (3)

wherein, in the formula (3), M represents germanium, tin or lead.

According to other aspect of the invention made for solving the aforementioned problems, a pattern-forming method includes: applying the radiation-sensitive composition of the one aspect of the invention directly or indirectly on a substrate to provide a film; exposing the film; and developing the film exposed.

The term "metal oxide" as referred to herein means a compound that includes at least a metal atom and an oxygen atom. The term "organic group" as referred to herein means a group having at least one carbon atom.

### [Effects of the Invention]

The radiation-sensitive composition and pattern-forming method according to the aspects of the present invention enable a pattern superior in etching resistance to be formed with superior sensitivity being achieved. Therefore, these can be suitably used in manufacture of semiconductor devices in which further progress of miniaturization is expected in the future.

### [Description of Embodiments]

### Radiation-Sensitive Composition

The radiation-sensitive composition of one embodiment of the invention contains: a metal oxide (hereinafter, may be also referred to as "(A) metal oxide" or "metal oxide (A)") having a first structural unit (hereinafter, may be also referred to as "structural unit (I)") represented by the following formula (1), the following formula (2) or a combination thereof, and a second structural unit (hereinafter, may be also referred to as "structural unit (II)") represented by the following formula (3); and a solvent (hereinafter, may be also referred to as "(B) solvent" or "solvent (B)"). The radiation-sensitive composition may further contain optional component(s) such as a radiation-sensitive base generator (hereinafter, may be also referred to as "(C) base generator" or "base generator (C)"), and (D) a surfactant described later, within a range not leading to impairment of the effects of the present invention. The radiation-sensitive composition can be suitably used for a pattern-forming method in which an exposure with an extreme ultraviolet ray or an electron beam is conducted. Hereinafter, each component will be described.

### (A) Metal Oxide

The metal oxide (A) has the structural unit (I) and the structural unit (II). The me tal oxide (A) may further have an arbitrary structural unit such as a structural unit (III) as described later. In the radiation-sensitive composition, the metal oxide (A) may be used ei ther alone of one type, or in combination of two or more types thereof. The metal oxide ( A) serves as a principal component of the film formed from the radiation-sensitive composit ion. The term "principal component" as referred to herein means a component which is of the highest content, for example, a component the content of which is no less than 50% by mass.

Due to having both the structural unit (I) and the structural unit (II) in the metal oxide (A), the radiation-sensitive composition is superior in sensitivity, and enables a pattern superior in etching resistance to be formed. Although not necessarily clarified and without wishing to be bound by any theory, the reason for achieving the effects described above due to the radiation-sensitive composition having the aforementioned constitution is inferred as in the following, for example. Specifically, when the metal oxide (A) is affected by exposure light such as EUV or an electron beam, radical formation (elimination of the organic group) is believed to occur in the following formula (1) through cleavage of a metal-carbon covalent bond between the metal atom represented by M and the organic group which bonds to M via a carbon atom in the structural unit (I). Thus, it is considered that at a light-exposed region of the film formed from the radiation-sensitive composition, metal oxide (A) molecules that form radicals are bonded to each other to increase in the molecular weight, leading to a change in solubility in a developer solution, whereby pattern formation is enabled. In this regard, it is believed that due to the metal oxide (A) having the structural unit (II) represented by MO_{4/2} in addition to the structural unit (I), formation of a film is enabled with higher density. As a result, it is considered that absorptivity of EUV and the like of the film thus formed is enhanced, thereby leading to improved sensitivity, as well as improved etching resistance through increasing the density of the film formed. Hereinafter, each structural unit will be described.

### Structural Unit (I)

The structural unit (I) is represented by the following formula (1), the following formula (2) or a combination thereof. 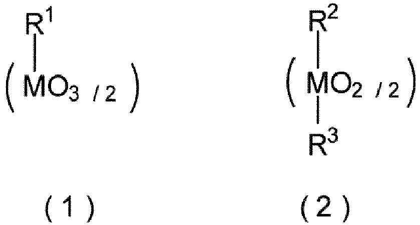 In the above formulae (1) and (2), Ms each independently represent germanium, tin or lead. R¹, R² and R³ each independently represent a monovalent organic group having 1 to 40 carbon atoms which bonds to M via a carbon atom.

As M, tin and germanium are preferred.

The monovalent organic group having 1 to 40 carbon atoms which bonds to M via a carbon atom represented by R¹, R² or R³ is exemplified by: a monovalent hydrocarbon group having 1 to 40 carbon atoms; a group (α) having 1 to 40 carbon atoms that includes a divalent hetero atom-containing group between two adjacent carbon atoms of a hydrocarbon group; a group obtained by substituting a part or all of hydrogen atoms included in the hydrocarbon group or the group (α) with a monovalent hetero atom-containing group; and the like.

The "hydrocarbon group" herein may include a chain hydrocarbon group, an alicyclic hydrocarbon group and an aromatic hydrocarbon group. This "hydrocarbon group" may be a saturated hydrocarbon group or an unsaturated hydrocarbon group. The "chain hydrocarbon group" as referred to herein means a hydrocarbon group not including a ring structure but comprising only a chain structure, and both a straight chain hydrocarbon group and a branched hydrocarbon group may be involved. The "alicyclic hydrocarbon group" as referred to herein means a hydrocarbon group not including an aromatic ring structure but comprising only an alicyclic structure as the ring structure, and both a monocyclic alicyclic hydrocarbon group and a polycyclic alicyclic hydrocarbon group may be involved. However, the alicyclic hydrocarbon group does not need to be constituted with only the alicyclic structure, and a part thereof may include a chain structure. The "aromatic hydrocarbon group" as referred to herein means a hydrocarbon group including an aromatic ring structure as the ring structure. However, the aromatic hydrocarbon group does not need to be constituted with only the aromatic ring structure, and a part thereof may include a chain structure and/or an alicyclic structure. The number of "ring atom" as referred to herein means the number of atoms constituting the ring in an aromatic ring structure, an aromatic heterocyclic structure, an alicyclic structure or an aliphatic heterocyclic structure, and in the case of a polycyclic ring structure, the number of "ring atoms" means the number of atoms constituting the polycyclic structure.

The monovalent hydrocarbon group having 1 to 40 carbon atoms is exemplified by a monovalent chain hydrocarbon group having 1 to 40 carbon atoms, a monovalent alicyclic hydrocarbon group having 3 to 40 carbon atoms, a monovalent aromatic hydrocarbon group having 6 to 40 carbon atoms, and the like.

Examples of the monovalent chain hydrocarbon group having 1 to 40 carbon atoms include:
alkyl groups such as a methyl group, an ethyl group, a n-propyl group and an i-propyl group;
alkenyl groups such as an ethenyl group, a propenyl group and a butenyl group;
alkynyl groups such as an ethynyl group, a propynyl group and a butynyl group; and the like.

Examples of the monovalent alicyclic hydrocarbon group having 3 to 40 carbon atoms include:
monocyclic alicyclic saturated hydrocarbon groups such as a cyclopentyl group and a cyclohexyl group;
monocyclic alicyclic unsaturated hydrocarbon groups such as a cyclopentenyl group and a cyclohexenyl group;
polycyclic alicyclic saturated hydrocarbon groups such as a norbornyl group, an adamantyl group and a tricyclodecyl group;
polycyclic alicyclic unsaturated hydrocarbon groups such as a norbornenyl group and a tricyclodecenyl group; and the like.

Examples of the monovalent aromatic hydrocarbon group having 6 to 40 carbon atoms include
aryl groups such as a phenyl group, a tolyl group, a xylyl group, a naphthyl group and an anthryl group;
aralkyl groups such as a benzyl group, a phenethyl group, a naphthylmethyl group and an anthrylmethyl group; and the like.

The hetero atom that may constitute the monovalent or divalent hetero atom-containing group is exemplified by an oxygen atom, a nitrogen atom, a sulfur atom, a phosphorus atom, a silicon atom, a halogen atom and the like. Examples of the halogen atom include a fluorine atom, a chlorine atom, a bromine atom, an iodine atom and the like. The number of carbon atoms of the monovalent or divalent hetero atom-containing group is, for example, 0 to 20, preferably 0 to 10, and more preferably 0 to 5.

Examples of the divalent hetero atom-containing group include -O-, -CO-, -S-, -CS-, -NR'-, groups obtained by combining at least two of the same, and the like, wherein R' represents a hydrogen atom or a monovalent hydrocarbon group. Of these, the divalent hetero atom-containing group is preferably -O-.

Examples of the monovalent hetero atom-containing group include halogen atoms such as a fluorine atom, a chlorine atom, a bromine atom and an iodine atom, a hydroxy group, a carboxy group, a cyano group, an amino group, a sulfanyl group (-SH) and the like. Of these, a fluorine atom is preferred.

The upper limit of the number of carbon atoms in the monovalent organic group represented by R¹, R² or R³ is preferably 30, more preferably 20, still more preferably 10, and particularly preferably 5.

The monovalent organic group represented by R¹ in the above formula (1) or R² in the above formula (2) is exemplified by: a monovalent hydrocarbon group having 1 to 20 carbon atoms; a monovalent hydrocarbon group having 1 to 20 carbon atoms in which at least a part of hydrogen atoms thereof is substituted with a substituent (hereinafter, may be also referred to as "substituent (a)"); and the like.

The upper limit of the number of carbon atoms in the monovalent hydrocarbon group represented by R¹ or R² is preferably 15, more preferably 10, and still more preferably 5. The number of carbon atoms of the substituent (a) is for example, 0 to 30.

The substituent (a) for the hydrocarbon group is exemplified by an unsaturated bond-containing group, an electron attractive group, and the like.

The unsaturated bond-containing group as the substituent (a) is exemplified by an aromatic group, an ethylenic double bond-containing group, an acetylenic triple bond-containing group, and the like.

The term "aromatic group" as referred to herein means a group that includes one or a plurality of aromatic rings, and examples thereof include:
aryl groups such as a phenyl group, a tolyl group, a xylyl group, a naphthyl group and an anthryl group;
substituted aryl groups obtained by substituting a part or all of hydrogen atoms included in the aryl group with a hetero atom-containing group;
arylene groups having 6 to 30 carbon atoms such as a phenylene group, a tolylene group, a xylylene group, a naphthylene group and an anthrylene group;
substituted arylene groups obtained by substituting a part or all of hydrogen atoms included in the arylene group with a hetero atom-containing group; and the like.

Examples of the hetero atom-containing group that substitutes for the aryl group or the arylene group include halogen atoms such as a fluorine atom, a chlorine atom, a bromine atom and an iodine atom, a hydroxy group, a carboxy group, a cyano group, an amino group, a sulfanyl group (-SH), and the like.

Examples of the ethylenic double bond-containing group include:
alkenyl groups having 2 to 30 carbon atoms such as an ethenyl group, a propenyl group and a butenyl group;
alkenediyl groups having 2 to 30 carbon atoms such as an ethenediyl group, a propenediyl group and a butenediyl group;
alicyclic unsaturated hydrocarbon groups having 3 to 30 carbon atoms and having a double bond, such as a cyclopropenyl group, a cyclopentenyl group, a cyclohexenyl group and a norbornenyl group; and the like.

Examples of the acetylenic triple bond-containing group include:
alkynyl groups having 2 to 30 carbon atoms such as an ethynyl group, a propynyl group and a butynyl group;
alkynediyl groups having 2 to 30 carbon atoms such as an ethynediyl group, a propynediyl group and a butynediyl group; and the like.

The unsaturated bond-containing group is preferably an aromatic group or an ethylenic double bond-containing group, more preferably an aryl group or an alkenyl group, and still more preferably a phenyl group or an ethenyl group.

Examples of the electron attractive group as the substituent (a) include:
monovalent groups such as a cyano group, a nitro group, a halogenated alkyl group, - COOR", -SO₂R", a cationic group and an alkoxy group (wherein, the group does not bond to the aromatic ring of the hydrocarbon group);
divalent groups such as -COO- and -SO₂-; and the like.
R" represents a hydrogen atom or a monovalent hydrocarbon group.

The upper limit of the number of carbon atoms of the halogenated alkyl group, - COOR", -SO₂R", the cationic group and the alkoxy group is preferably 20, more preferably 10, and still more preferably 3.

Examples of the halogenated alkyl group include a fluorinated alkyl group, a chlorinated alkyl group, a brominated alkyl group, and the like. Of these, a fluorinated alkyl group is preferred, a perfluoroalkyl group is more preferred, and a trifluoromethyl group is still more preferred.

Examples of the cationic group include an ammonium group, a phosphonium group, a sulfonium group, an iodonium group, a diazonium group, and the like.

Examples of the alkoxy group include a methoxy group, an ethoxy group, a n-propoxy group, an i-propoxy group, and the like.

The electron attractive group is preferably a cyano group, a nitro group, a halogenated alkyl group, -COOR", -COO- or a cationic group.

R¹ in the above formula (1), and R² in the above formula (2) each represent preferably a monovalent hydrocarbon group having 1 to 20 carbon atoms, or a monovalent hydrocarbon group having 1 to 20 carbon atoms in which at least a part of hydrogen atoms thereof is substituted with the substituent (a), and more preferably a monovalent hydrocarbon group having 1 to 20 carbon atoms in which at least a part of hydrogen atoms thereof is substituted with the substituent (a) that is an unsaturated bond-containing group, an electron attractive group or a combination thereof. Furthermore, in addition to R¹ and R² being as defined above, it is particularly preferred that R³ in the above formula (2) is also as defined above. When at least one of R¹, R² and R³ in the structural unit (I) of the metal oxide (A) represents the hydrocarbon group substituted with the substituent (a) that is the unsaturated bond-containing group, the electron attractive group or a combination thereof, it is believed that stability in radical formation from the metal oxide (A) is enhanced, consequently leading to more improved sensitivity of the radiation-sensitive composition.

The substituent (a) for the hydrocarbon group is preferably: a substituent that is a monovalent organic group having 2 to 30 carbon atoms which includes an unsaturated bond-containing group, and bonds to a methanediyl group bonding to M via one of carbon atoms constituting the unsaturated bond (hereinafter, may be also referred to as "substituent (a1)"); a substituent that is a monovalent organic group having 1 to 30 carbon atoms which includes a divalent electron attractive group, and bonds to the methanediyl group bonding to M via the divalent electron attractive group (hereinafter, may be also referred to as "substituent (a2)"); or a monovalent electron attractive group. When the carbon atom or the electron attractive group constituting the unsaturated bond is thus bonded to M via the methanediyl group, a further improvement of the stability in radical formation by these substituents is enabled. As a result, radical formation from the metal oxide (A) can be more promoted, thereby enabling the sensitivity of the radiation-sensitive composition to be further improved. In addition, in the case in which the substituent (a) is the substituent (a1), etching resistance of a metal-containing film formed from the radiation-sensitive composition can be more improved.

Examples of the substituent (a1) include groups represented by the following formulae (A-1) to (A-3), and the like.

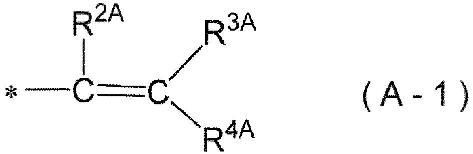

*-C≡C-R^{5A} (A-2)

*-Ar (A-3)

In the above formulae (A-1) to (A-3), * denotes a binding site to the methanediyl group bonding to M.
In the above formula (A-1), R^{2A} to R^{4A} each independently represent a hydrogen atom or a monovalent organic group having 1 to 28 carbon atoms, or two or more of R^{2A} to R^{4A} taken together represent a ring structure having 3 to 30 ring atoms together with the carbon atom or the carbon chain to which the two or more of R^{2A} to R^{4A} bond.
In the above formula (A-2), R^{5A} represents a monovalent organic group having 1 to 28 carbon atoms.
In the above formula (A-3), Ar represents a substituted or unsubstituted aryl group having 6 to 30 carbon atoms.

The number of carbon atoms of the monovalent organic group which may be represented by R^{2A} to R^{5A} is preferably 1 to 20, more preferably 1 to 10, and still more preferably 1 to 3.

Examples of the monovalent organic group which may be represented by R^{2A} to R^{5A} include groups similar to the groups exemplified as the monovalent organic group which may be represented by R¹ to R³ in the above formulae (1) and (2), and the like.

Examples of the ring structure having 3 to 30 ring atoms which may be taken together represented by two or more of R^{2A} to R^{4A} together with the carbon atom or the carbon chain to which the two or more of R^{2A} to R^{4A} bond include alicyclic structures such as a cycloalkane structure, as well as aliphatic heterocyclic structures such as a lactone ring structure, and the like.

R^{2A} to R^{5A} each represent preferably a hydrogen atom or a monovalent hydrocarbon group, more preferably a hydrogen atom or a monovalent chain hydrocarbon group, and still more preferably a hydrogen atom or an alkyl group, and particularly preferably a hydrogen atom.

Examples of the aryl group represented by Ar and the substituent therefor include similar groups to the aryl group and the substituent therefor exemplified as the aromatic group of the unsaturated bond-containing group in the substituent (a) for the hydrocarbon group, and the like.

The number of carbon atoms of the aryl group represented by Ar is preferably 6 to 20, and more preferably 6 to 10.

The aryl group represented by Ar is preferably a phenyl group.

Examples of the substituent (a2) include groups represented by the following formula (A-4), and the like.

*-W-R^{6A} (A-4)

In the above formula (A-4), W represents a divalent electron attractive group; and R^{6A} represents an organic group having 1 to 29 carbon atoms.

Examples of the divalent electron attractive group represented by W include the divalent groups, of the groups exemplified for the electron attractive group as the substituent (a), and the like.

Examples of the monovalent organic group represented by R^{6A} include groups similar to the groups exemplified as the monovalent organic group which may be represented by R¹ to R³ in the above formulae (1) and (2), and the like. The number of carbon atoms of the monovalent organic group represented by R^{6A} is preferably 1 to 20, more preferably 1 to 10, and still more preferably 1 to 3.

The monovalent organic group represented by R^{6A} is preferably a monovalent hydrocarbon group, more preferably a monovalent chain hydrocarbon group, still more preferably an alkyl group, and particularly preferably a methyl group.

The monovalent organic group having 1 to 40 carbon atoms which bonds to M via a carbon atom, represented by R¹, R² and R³ is preferably a monovalent hydrocarbon group, a monovalent fluorinated hydrocarbon group or a monovalent cyano hydrocarbon group, more preferably a monovalent chain hydrocarbon group, a monovalent aromatic hydrocarbon group, a monovalent fluorinated chain hydrocarbon group or a monovalent cyano chain hydrocarbon group, still more preferably an alkyl group, an alkenyl group, an aryl group, an aralkyl group, a fluorinated alkyl group or a cyanoalkyl group, and particularly preferably an i-propyl group, a t-butyl group, an allyl group, a phenyl group, a benzyl group, a trifluoromethyl group, a trifluoroethyl group or a cyanomethyl group.

As the structural unit represented by the above formula (1), examples of the structural unit (I) include structural units represented by the following formulae, and the like. 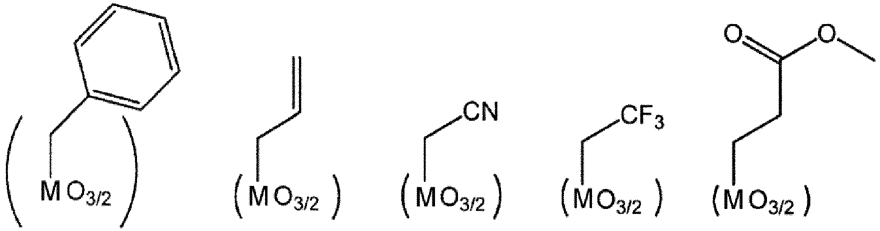 In the above formulae, M is as defined in the above formula (1).

Of these, a benzylmetalloxane unit is preferred, and benzylstanoxane unit is more preferred.

Furthermore, as the structural unit represented by the above formula (2), examples of the structural unit (I) include structural unit represented by the following formulae, and the like. 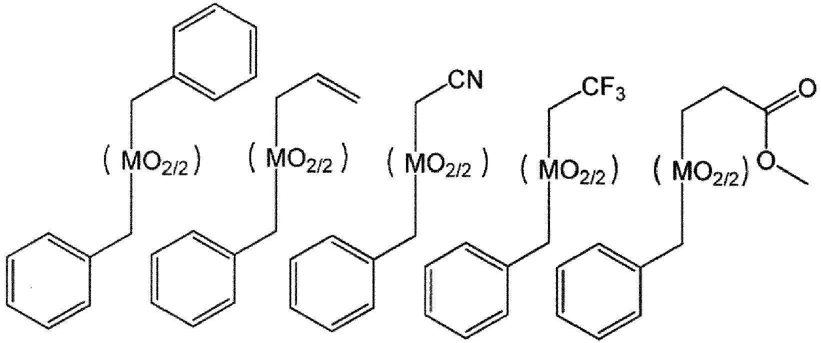 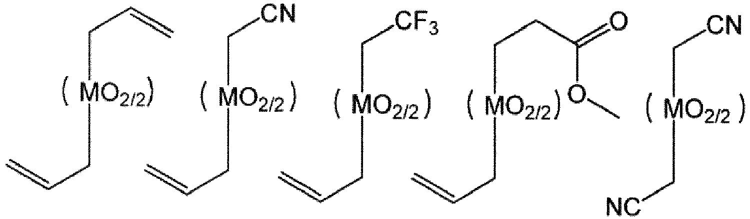 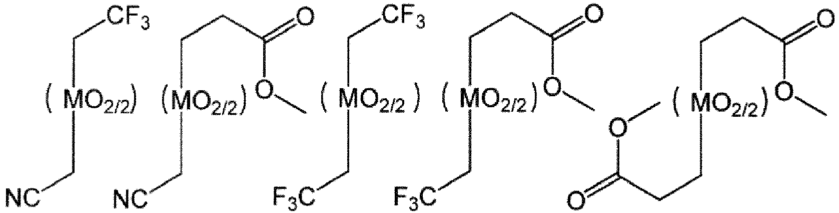 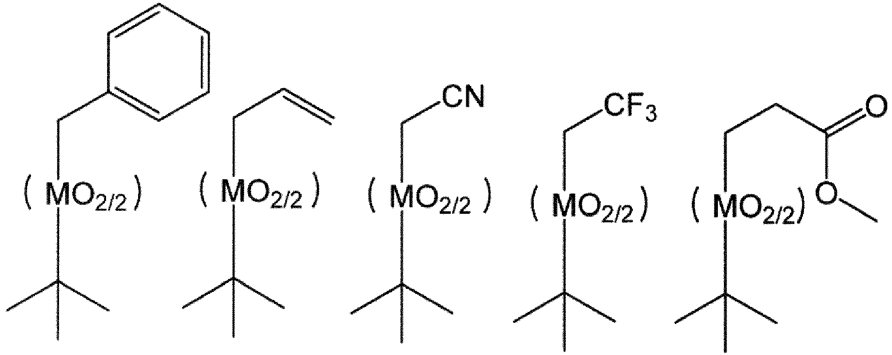 In the above formulae, M is as defined in the above formula (2).

The lower limit of the proportion of the structural unit (I) contained with respect to the total structural units constituting the metal oxide (A) is preferably 20 mol%, more preferably 50 mol%, still more preferably 70 mol%, particularly preferably 80 mol%, and most preferably 90 mol%. Meanwhile, the upper limit of the proportion of the structural unit (I) contained is preferably 99 mol%, and more preferably 98 mol%. When the proportion of the structural unit (I) contained falls within the above range, the sensitivity and the etching resistance can be more improved.

### Structural Unit (II)

The structural unit (II) is represented by the following formula (3).

(MO_{4/2}) (3)

In the above formula (3), Ms each independently represent germanium, tin or lead.

The lower limit of the proportion of the structural unit (II) contained with respect to the total structural units constituting the metal oxide (A) is preferably 1 mol%, more preferably 3 mol%, and still more preferably 5 mol%. The upper limit of the proportion of the structural unit (II) contained is preferably 50 mol%, more preferably 30 mol%, and still more preferably 10 mol%. When the proportion of the structural unit (II) contained falls within the above range, the sensitivity and the etching resistance can be more improved.

The lower limit of the proportion of the total of the structural unit (I) and the structural unit (II) contained with respect to the total structural units constituting the metal oxide (A) is preferably 50 mol%, more preferably 70 mol%, still more preferably 90 mol%, and particularly preferably 95 mol%. The upper limit of the proportion of the total is, for example, 100 mol%.

The lower limit of the molar ratio of the proportion of the structural unit (I) contained to the proportion of the structural unit (II) contained is preferably 20/80, more preferably 50/50, and still more preferably 70/30. The upper limit of the molar ratio of is preferably 99/1, and more preferably 98/2. When the molar ratio of the structural unit (I)/ the structural unit (II) falls within the above range, both the sensitivity and the etching resistance can be enhanced to a more desired level.

### Structural Unit (III)

The metal oxide (A) may also have a structural unit (III) represented by the following formula (4). 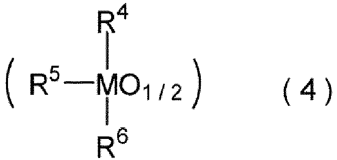 In the above formula (4), M represents germanium, tin or lead; and R⁴ to R⁶ each independently represent a monovalent organic group having 1 to 40 carbon atoms which bonds to M via a carbon atom.

Examples of the monovalent organic group represented by R⁴ to R⁶ include groups similar to the groups exemplified as the monovalent organic group which may be represented by R¹ to R³ in the above formulae (1) and (2), and the like.

Examples of the structural unit (III) include structural units represented by the following formula, and the like. 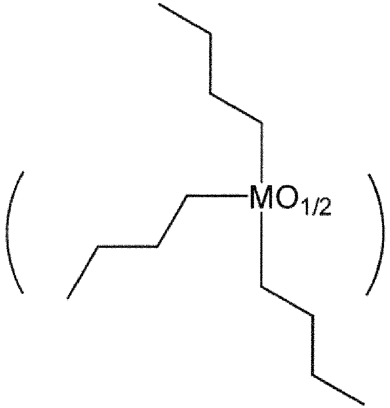 In the above formula, M is as defined in the above formula (4).

In a case in which the metal oxide (A) has the structural unit (III), the lower limit of the proportion of the structural unit (III) with respect to the total structural units constituting the metal oxide (A) is preferably 1 mol%, more preferably 2 mol%, and still more preferably 3 mol%. Meanwhile, the upper limit of the proportion of the structural unit (III) contained is preferably 20 mol%, more preferably 10 mol%, and still more preferably 7 mol%.

The metal oxide (A) may have a structural unit other than the structural units (I) to (III). In a case in which the metal oxide (A) has the other structural unit, the upper limit of the proportion of the other structural unit contained is preferably 10 mol%, and more preferably 5 mol%.

The lower limit of the weight-average molecular weight (Mw) of the metal oxide (A) is preferably 700, more preferably 1,000, still more preferably 1,200, and particularly preferably 1,400. The upper limit of the Mw is preferably 20,000, more preferably 10,000, still more preferably 8,000, and particularly preferably 7,000. When the Mw of the metal oxide (A) falls within the above range, the sensitivity and the etching resistance can be more improved.

The Mw of the metal oxide (A) is herein a value determined by using gel permeation chromatography (GPC) under the following conditions.

GPC columns: for example, "G2000HXL" x 2, "G3000HXL" x 1 and "G4000HXL" x 1, available from Tosoh Corporation;
column temperature: 40 °C;
elution solvent: tetrahydrofuran;
flow rate: 1.0 mL/min;
sample concentration: 1.0% by mass;
amount of injected sample: 100 µL;
detector: differential refractometer; and
standard substance: mono-dispersed polystyrene

The lower limit of the content of the metal oxide (A) in terms of solid content equivalent in the radiation-sensitive composition is preferably 50% by mass, preferably 70% by mass, and still more preferably 90% by mass. The term "solid content" as referred to herein means component(s) other than the solvent (B) in the radiation-sensitive composition.

### Synthesis Method of Metal Oxide (A)

The metal oxide (A) may be obtained by, for example, a condensation reaction, etc., using: at least one compound represented by the following formulae (i) to (v) that gives the structural unit (I); and a compound represented by MJ₄ (wherein, M represents germanium, tin or lead; and Js each independently represent a halogen atom, -OR^{A} or -OCOR^{B}, wherein R^{A} and R^{B} each independently represent a hydrogen atom or a monovalent organic group having 1 to 20 carbon atoms) that gives the structural unit (II), in the presence of a catalyst, e.g., a quaternary ammonium salt such as hydroxylated tetramethyl ammonium. 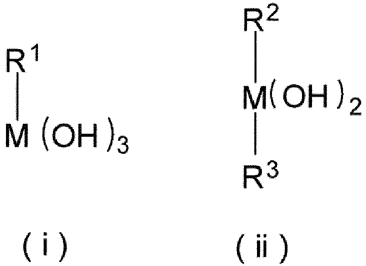 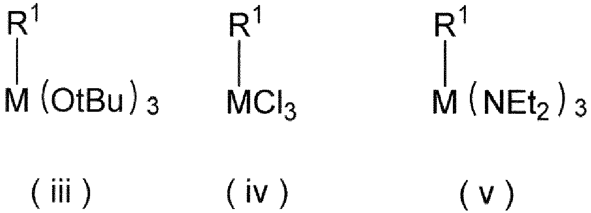 In the above formulae (i) to (v), M and R¹ to R³ are as defined in the above formulae (1) to (2).

Examples of the halogen atom which may be represented by J include a chlorine atom, a fluorine atom, an iodine atom and the like, and a chlorine atom is preferred.

R^{A} and R^{B} represent preferably a monovalent organic group, more preferably a monovalent hydrocarbon group, still more preferably a monovalent chain hydrocarbon group, and particularly preferably an alkyl group. Moreover, the upper limit of the number of carbon atoms of the monovalent organic group represented by R^{A} or R^{B} is preferably 10, more preferably 5, and still more preferably 2.

By using, for example, tri-n-butyltin chloride or the like together with a compound that provides the structural unit (I) and a compound that provides the structural unit (II) in the condensation reaction, the metal oxide (A) having the structural unit (III) can be obtained.

### (B) Solvent

The solvent (B) is not particularly limited as long as it is a solvent capable of dissolving or dispersing at least the metal oxide (A), optional component(s) which may be contained as needed, and the like. It is to be noted that a solvent for the reaction used in the synthesis of the metal oxide (A) may be directly used as the solvent (B).

The solvent (B) is exemplified by organic solvents such as an alcohol solvent, an ether solvent, a ketone solvent, an amide solvent, an ester solvent, a hydrocarbon solvent and the like.

Examples of the alcohol solvent include:
monohydric alcohol solvents such as methanol, ethanol, n-propanol, iso-propanol, n-butanol, iso-butanol, sec-butanol, tert-butanol and 4-methyl-2-pentanol;
polyhydric alcohol solvents such as ethylene glycol, 1,2-propylene glycol and 1,3-butylene glycol;
polyhydric alcohol partial ether solvents such as ethylene glycol monomethyl ether, ethylene glycol monoethyl ether, ethylene glycol monopropyl ether, propylene glycol monomethyl ether and propylene glycol monoethyl ether; and the like.

As the organic solvent, any of the solvents disclosed in US 2016/0011513, and the like may be used.

Alternatively, the solvent (B) may be a mixed solvent containing the organic solvent as a principal component, and a small amount of water. When the solvent (B) is such a mixed solvent, hydration of the metal oxide (A) is enabled, and as a result, storage stability of the radiation-sensitive composition can be improved. Furthermore, an increase in molecular weight of the metal oxide (A) can be promoted in pattern formation.

The lower limit of the content of water in the mixed solvent is preferably 0.01% by mass, more preferably 0.1% by mass, and still more preferably 1% by mass. Meanwhile, the upper limit of the content of water is preferably 20% by mass, and more preferably 10% by mass. When the content of water falls within the above range, further superior storage stability, as well as more improved uniformity of the film to be formed is enabled.

The solvent (B) is preferably an organic solvent, and more preferably an alcohol solvent. When the solvent (B) is the solvent as described above, the radiation-sensitive composition can be superior in coating characteristics. The number of carbon atoms of the alcohol solvent is preferably no less than 1 and no greater than 10. The radiation-sensitive composition may contain one, or two or more types of the solvent (B).

### (C) Base Generator

The base generator (C) generates a base in a light-exposed region through a direct action by way of exposure light, as well as an action by a secondary electron generated from the metal oxide (A) resulting from the exposure light. It is considered that due to containing the base generator (C), the radiation-sensitive composition enables an increase in molecular weight of the metal oxide (A) in the light-exposed region by the base, thereby consequently enabling the sensitivity of the radiation-sensitive composition to be more improved. The base generator (C) in the radiation-sensitive composition may be contained in the form of a free compound (hereinafter, may be appropriately referred to as "(C) base generator" or "base generator (C)") or in the form incorporated as a part of other polymer, or may be in both of these forms.

The base generator (C) is exemplified by complexes of transition metals such as cobalt (hereinafter, may be also referred to as "transition metal complex"), nitrobenzyl carbamates, α,α-dimethyl-3,5-dimethoxybenzyl carbamates, acyloxyiminos, and the like. Specific examples of the base generator (C) include compounds disclosed in paragraphs [0272] to [0276] of Japanese Unexamined Patent Application, Publication No. 2016-200698, and the like.

In a case in which the radiation-sensitive composition contains the base generator (C), the lower limit of the content of the base generator (C) with respect to 100 parts by mass of the metal oxide (A) is preferably 0.1 parts by mass, more preferably 1 part by mass, and still more preferably 3 parts by mass. Meanwhile, the upper limit of the content is preferably 10 parts by mass, and more preferably 5 parts by mass.

### (D) Surfactant

The surfactant (D) achieves the effect of improving the coating characteristics, striation, developability and the like of the radiation-sensitive composition. The surfactant is preferably, for example, a nonionic surfactant. Specific examples of the surfactant which may be used include those disclosed in paragraph [0140] of Japanese Unexamined Patent Application, Publication No. 2009-134088, and the like. The surfactant (D) may be used either alone of one type, or in combination of two or more types thereof.

In a case in which the radiation-sensitive composition contains the surfactant (D), the lower limit of the content of the surfactant with respect to 100 parts by mass of the metal oxide (A) is preferably 0.1 parts by mass, and more preferably 0.3 parts by mass. Meanwhile, the upper limit of the content is preferably 2 parts by mass, and more preferably 1 part by mass.

### Other Optional Components

The radiation-sensitive composition may contain in addition to the components (A) to (D), an acid generator, an acid diffusion controller, a fluorine atom-containing polymer and the like, for example, as other optional components (excluding the component (A)). The radiation-sensitive composition may contain one, or two or more types of each of the other optional components.

### Acid Generator

The acid generator is a substance that generates an acid in a light-exposed region through an action by way of exposure light, etc. It is considered that due to containing the acid generator, the radiation-sensitive composition enables an increase in molecular weight of the metal oxide (A) in the light-exposed region by the acid, thereby consequently enabling the sensitivity of the radiation-sensitive composition to be more improved. The acid generator in the radiation-sensitive composition acid may be contained in the form of a low-molecular weight compound (hereinafter, may be also referred to as "acid generating agent" as appropriate) or in the form incorporated as a part of the other polymer, etc., or may be in both of these forms.

The acid generating agent is exemplified by an onium salt compound, an N-sulfonyloxyimide compound, a halogen-containing compound, a diazo ketone compound, and the like.

Examples of the onium salt compound include a sulfonium salt, a tetrahydrothiophenium salt, an iodonium salt, a phosphonium salt, a diazonium salt, a pyridinium salt, and the like.

Specific examples of the acid generating agent include compounds disclosed in paragraphs [0080] to [0113] of Japanese Unexamined Patent Application, Publication No. 2009-134088, and the like.

In a case in which the radiation-sensitive composition contains the acid generating agent, the content of the acid generating agent with respect to 100 parts by mass of the metal oxide (A) may be, for example, no less than 0.1 parts by mass and no greater than 30 parts by mass.

### Acid Diffusion Controller

The acid diffusion controller controls a phenomenon of diffusion of the acid, which was generated from the acid generator, etc. upon the exposure, in the film, whereby the effect of inhibiting unwanted chemical reactions in an unexposed region is exhibited. In addition, the storage stability of the radiation-sensitive composition is more improved and the resolution thereof is improved. Moreover, in pattern formation conducted by using the radiation-sensitive composition, inhibition of variation of the line width of the pattern caused by variation of post-exposure time delay from the exposure until a development treatment, i.e., improvement of process stability is enabled. The acid diffusion controller may be contained in the radiation-sensitive composition in the form of a free compound (hereinafter, may be referred to as "acid diffusion control agent" as appropriate) or in the form incorporated as a part of the other polymer, or may be in both of these forms.

The acid diffusion control agent is exemplified by a compound having one nitrogen atom in a single molecule, a compound having two nitrogen atoms in a single molecule, a compound having three nitrogen atoms, an amide group-containing compound, a urea compound, a nitrogen-containing heterocyclic compound, and the like. Alternatively, a photolabile base that generates a weak acid through photosensitization upon an exposure may be used as the acid diffusion control agent.

Specific examples of the acid diffusion control agent include compounds disclosed in US 2016/0011513, and the like.

In a case in which the radiation-sensitive composition contains the acid diffusion control agent, the content of the acid diffusion control agent with respect to 100 parts by mass of the metal oxide (A) may be, for example, no less than 0.1 parts by mass and no greater than 20 parts by mass.

### Preparation Method of Radiation-Sensitive Composition

The radiation-sensitive composition may be prepared, for example, by mixing at a certain ratio, the metal oxide (A) and the solvent (B), as well as the optional component(s) that may be used as needed, such as the base generator (C) and the surfactant (D), preferably followed by filtering a thus obtained mixture through a membrane filter, etc. having a pore size of about 0.2 µm. The lower limit of the solid content concentration of the radiation-sensitive composition is preferably 0.1% by mass, more preferably 0.5% by mass, still more preferably 1% by mass, and particularly preferably 1.5% by mass. The upper limit of the solid content concentration is preferably 50% by mass, more preferably 30% by mass, still more preferably 10% by mass, and particularly preferably 5% by mass.

### Pattern-Forming Method

The pattern-forming method of the embodiment of the invention includes the steps of: applying the radiation-sensitive composition of the above embodiment directly or indirectly on a substrate to provide a film (hereinafter, may be also referred to as "applying step"); exposing the film (hereinafter, may be also referred to as "exposure step"); and developing the film exposed (hereinafter, may be also referred to as "development step"). Since the radiation-sensitive composition of the embodiment of the present invention is used, the pattern-forming method enables a pattern superior in etching resistance to be formed with superior sensitivity being achieved. Each step will be described below.

### Applying Step

In this step, the radiation-sensitive composition is applied directly or indirectly on a substrate to provide a film. In this step, the radiation-sensitive composition is typically applied directly or indirectly on one face side of the substrate. The application procedure is not particularly limited, and application means such as e.g., spin-coating, cast coating or roll coating may be employed. Specifically, after the radiation-sensitive composition of the embodiment is applied such that the resultant film has a predetermined thickness, prebaking (PB) is executed as needed to evaporate off the solvent (B) and the like in the film. The substrate is exemplified by a silicon wafer, a wafer coated with aluminum, and the like.

The lower limit of the average thickness of the film is preferably 1 nm, more preferably 10 nm, still more preferably 20 nm, and particularly preferably 30 nm. Meanwhile, the upper limit of the average thickness is preferably 1,000 nm, more preferably 200 nm, still more preferably 100 nm, and particularly preferably 70 nm.

The lower limit of the temperature of PB is preferably 60 °C, and more preferably 80 °C. Meanwhile, the upper limit of the temperature of PB is preferably 140 °C, and more preferably 120 °C. The lower limit of the time period of PB is preferably 5 sec, and more preferably 10 sec. Meanwhile, the upper limit of the time period of PB is preferably 600 sec, and more preferably 300 sec.

In the pattern-forming method, in order to maximize the potential ability of the radiation-sensitive composition of the present embodiment, for example, an organic or inorganic antireflective film may be formed beforehand on the substrate employed. In addition, in order to prevent influences of basic impurities etc., included in the environment atmosphere, a protective film may be also provided on the film formed in this step, for example. Furthermore, in a case where an exposure by way of liquid immersion is carried out in the exposure step, in order to avoid direct contact of the film with the liquid immersion medium, a protective film for liquid immersion may be also provided on the film formed in this step, for example.

### Exposure Step

In this step, the film described above is exposed. The exposure is carried out by irradiating with a radioactive ray through a mask having a predetermined pattern via a liquid immersion medium such as water, as the case may be. Examples of the radioactive ray include: electromagnetic waves such as a visible light ray, an ultraviolet ray, a far ultraviolet ray, a vacuum ultraviolet ray (EUV; wavelength: 13.5 nm), an X-ray and a γ-ray; charged particle rays such as an electron beam and an α-ray; and the like. Of these, radioactive rays are preferred which are likely to allow the metal-carbon covalent bond included in the metal oxide (A) to be cleaved upon the exposure, and specifically, EUV and an electron beam are preferred.

In this step, post exposure baking (PEB) may be carried out after the exposure. The lower limit of the temperature of PEB is preferably 50 °C, and more preferably 80 °C. Meanwhile, the upper limit of the temperature of PEB is preferably 180 °C, and more preferably 130 °C. The lower limit of the time period of PEB is preferably 5 sec, and more preferably 10 sec. Meanwhile, the upper limit of the time period of PEB is preferably 600 sec, and more preferably 300 sec.

### Development Step

In this step, the film exposed in the exposure step is developed. A developer solution for use in the development is exemplified by a developer solution containing an aqueous alkali solution or an organic solvent, and the like.

Examples of the aqueous alkali solution include alkaline aqueous solutions prepared by dissolving at least one of alkaline compounds such as sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, ethyldimethylamine, triethanolamine, tetramethylammonium hydroxide (TMAH), pyrrole, piperidine, choline, 1,8-diazabicyclo-[5.4.0]-7-undecene and 1,5-diazabicyclo-[4.3.0]-5-nonene, and the like.

The lower limit of the content of the alkaline compound in the aqueous alkali solution is preferably 0.1% by mass, more preferably 0.5% by mass, and still more preferably 1% by mass. Meanwhile, the upper limit of the content is preferably 20% by mass, more preferably 10% by mass, and still more preferably 5% by mass.

The aqueous alkali solution is preferably an aqueous TMAH solution, and more preferably a 2.38% by mass aqueous TMAH solution.

Exemplary organic solvent in the developer solution containing the organic solvent includes those similar to the organic solvents exemplified for the solvent (B) of the radiation-sensitive composition, and the like. Of these, an ester solvent, an ether solvent, an alcohol solvent, a ketone solvent, an amide solvent, a hydrocarbon solvent or a combination thereof is preferably contained, and an ester solvent is more preferably contained. The developer solution is still more preferably a simple solvent of the ester solvent, and particularly preferably propylene glycol monomethyl ether acetate.

The lower limit of the content of the organic solvent in the developer solution containing the organic solvent is preferably 80% by mass, more preferably 90% by mass, still more preferably 95% by mass, and particularly preferably 99% by mass.

As the developer solution, the developer solution containing the organic solvent is preferred.

These developer solutions may be used either alone of one type, or two or more types thereof in combination. It is to be noted that the development is typically followed by washing with water, etc., and then drying.

A positive tone pattern can be obtained when the aqueous alkali solution is used as the developer solution. Whereas a negative tone pattern can be obtained when the developer solution containing the organic solvent is used as the developer solution.

### EXAMPLES

Hereinafter, the present invention is explained in detail by way of Examples, but the present invention is not in any way limited to these Examples.

### Synthesis of Metal Oxide

### Synthesis Example 1

Into 100 g of a 0.3 M aqueous hydroxylated tetramethyl ammonium solution, 9.50 mmol of tert-butyltin trichloride (a compound represented by the following formula (X-1) (hereinafter, may be also referred to as "compound (X-1)")) and 0.50 mmol of tetra-tert-butoxytin (a compound represented by the following formula (X-2) (hereinafter, may be also referred to as "compound (X-2)")) were charged, and the mixture was vigorously stirred at room temperature for 90 min. Thus separated precipitate was filtered out, and thereafter washed twice with 50 g of water, whereby a metal oxide (hereinafter, may be also referred to as "metal oxide (A-1)") represented by the following formula (A-1) was synthesized. The metal oxide (A-1) had Mw of 2,500. It is to be noted that Mw is a value determined by using gel permeation chromatography under the following conditions.
GPC columns: "G2000HXL" x 2, "G3000HXL" x 1 and "G4000HXL" x 1, available from Tosoh Corporation;
column temperature: 40 °C;
elution solvent: tetrahydrofuran;
flow rate: 1.0 mL/min;
sample concentration: 1.0% by mass;
amount of injected sample: 100 µL;
detector: differential refractometer; and
standard substance: mono-dispersed polystyrene
In addition, proportions of a structural unit derived from the compound (X-1) and a structural unit derived from the compound (X-2) contained in the metal oxide (A-1) were 95 mol% and 5 mol%, respectively, as determined by ¹¹⁹Sn-NMR measurement.

### Synthesis Examples 2 to 10 and Comparative Synthesis Examples 1 to 4

Metal oxides (A-2) to (A-10) and (a-1) to (a-4) represented by the following formulae were synthesized by similar operations to Synthesis Example 1 except that the type and the charging molar ratio of the monomer used were changed as shown in Table 1. Structures of compounds (X-1) to (X-8) as monomers are represented by the following formulae (X-1) to (X-8), respectively. The total number of moles of the monomer used was 10.00 mmol. It is to be noted that the proportion of each structural unit contained in each metal oxide synthesized was determined by a similar ¹¹⁹Sn-NMR measurement to Synthesis Example 1, and ascertained to be as each estimated from the charging molar ratio (mol%) of the compound that provides each structural unit.

### Synthesis Example 11

Into 100 g of a 0.3 M aqueous hydroxylated tetramethyl ammonium solution, 9.00 mmol of isopropyl(trichloro)gelmane (compound represented by the following formula (X-9)) and 1.00 mmol of tetraethoxygelmane (compound represented by the following formula (X-10)) were charged, and the mixture was vigorously stirred at room temperature for 90 min. Thus separated precipitate was filtered out, and thereafter washed twice with 50 g of water, whereby a metal oxide (hereinafter, may be also referred to as "metal oxide (A-11)") represented by the following formula (A-11) was synthesized. The metal oxide (A-11) had the Mw of 2,000.

### Comparative Synthesis Example 5

Into 100 g of a 0.3 M aqueous hydroxylated tetramethyl ammonium solution, 10.00 mmol of isopropyltrichlorogelmane (compound (X-9)) was charged, and the mixture was vigorously stirred at room temperature for 90 min. Thus separated precipitate was filtered out, and thereafter washed twice with 50 g of water, whereby a metal oxide (hereinafter, may be also referred to as "metal oxide (a-5)") represented by the following formula (a-5) was synthesized. The metal oxide (a-5) had the Mw of 1,900.

### Comparative Synthesis Example 6

Into 100 g of a 0.3 M aqueous hydroxylated tetramethyl ammonium solution, 10.00 mmol of tetraethoxygelmane (compound (X-10)) was charged, and the mixture was vigorously stirred at room temperature for 90 min. Thus separated precipitate was filtered out, and thereafter washed twice with 50 g of water, whereby a metal oxide (hereinafter, may be also referred to as "metal oxide (a-6)") represented by the following formula (a-6) was synthesized. The metal oxide (a-6) had the Mw of 2,100.

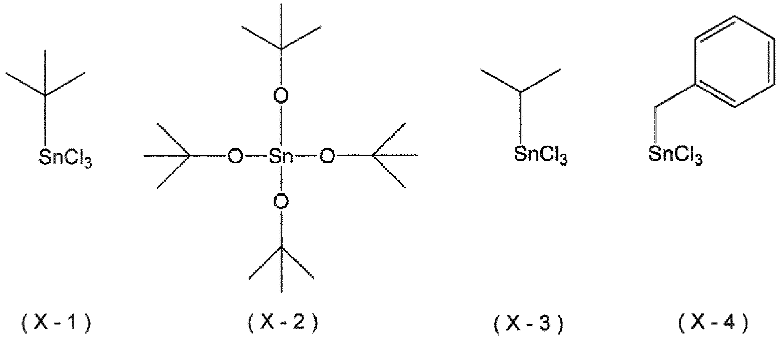

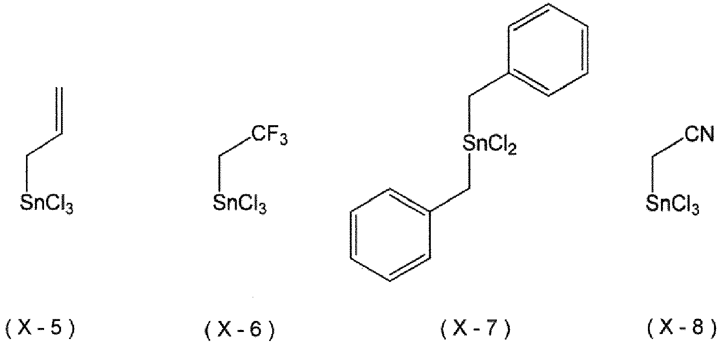

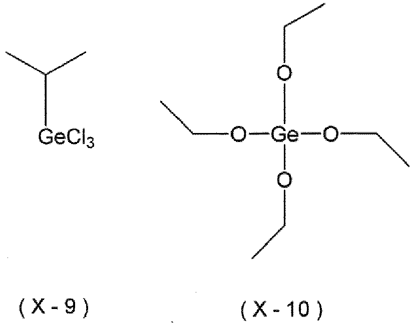

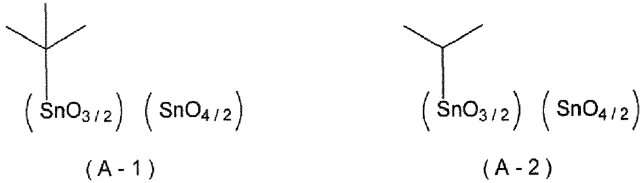

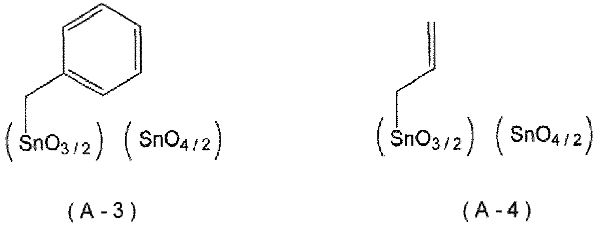

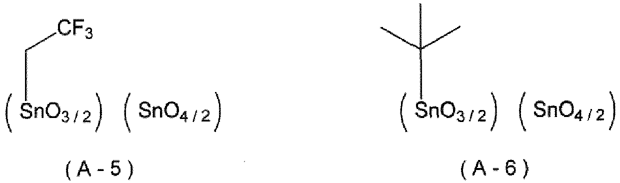

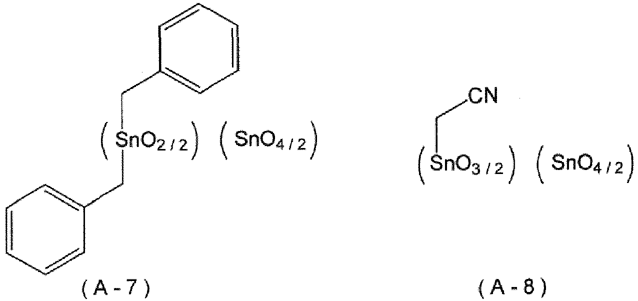

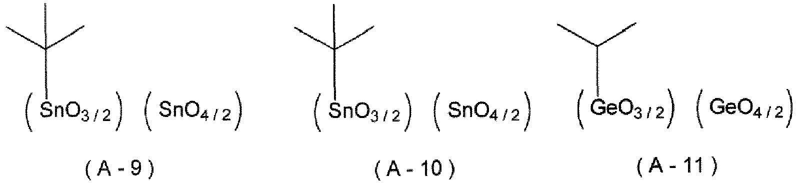

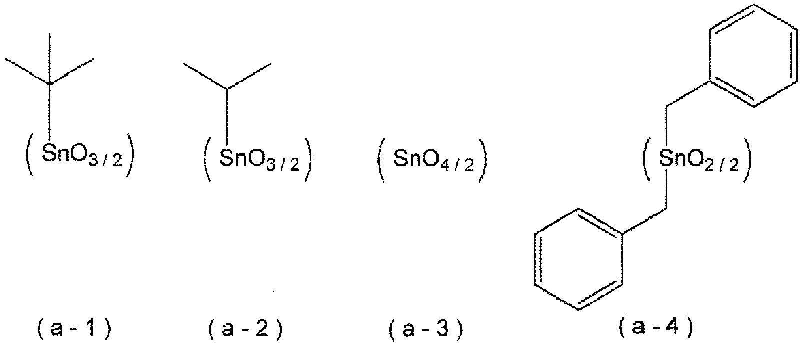

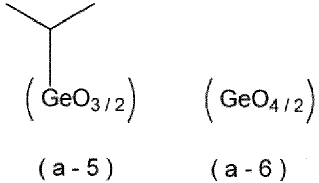

**Table 1**

| | (A) Component | Mw | Monomer that gives structural unit (I) | | Monomer that gives structural unit (II) | |
|---|---|---|---|---|---|---|
| | | | Type | Charging molar ratio (mol%) | Type | Charging molar ratio (mol%) |
| Synthesis Example 1 | A-1 | 2,500 | X-1 | 95 | X-2 | 5 |
| Synthesis Example 2 | A-2 | 2,400 | X-3 | 95 | X-2 | 5 |
| Synthesis Example 3 | A-3 | 2,400 | X-4 | 95 | X-2 | 5 |
| Synthesis Example 4 | A-4 | 2,500 | X-5 | 95 | X-2 | 5 |
| Synthesis Example 5 | A-5 | 2,300 | X-6 | 95 | X-2 | 5 |
| Synthesis Example 6 | A-6 | 2,400 | X-1 | 90 | X-2 | 10 |
| Synthesis Example 7 | A-7 | 2,500 | X-7 | 50 | X-2 | 50 |
| Synthesis Example 8 | A-8 | 2,400 | X-8 | 90 | X-2 | 10 |
| Synthesis Example 9 | A-9 | 2,400 | X-1 | 80 | X-2 | 20 |
| Synthesis Example 10 | A-10 | 2,400 | X-1 | 40 | X-2 | 60 |
| Synthesis Example 11 | A-11 | 2,000 | X-9 | 90 | X-10 | 10 |
| Comparative Synthesis Example 1 | a-1 | 2,500 | X-1 | 100 | - | - |
| Comparative Synthesis Example 2 | a-2 | 2,400 | X-3 | 100 | - | - |
| Comparative Synthesis Example 3 | a-3 | 2,400 | - | - | X-2 | 100 |
| Comparative Synthesis Example 4 | a-4 | 2,500 | X-7 | 100 | - | - |
| Comparative Synthesis Example 5 | a-5 | 1,900 | X-9 | 100 | - | - |
| Comparative Synthesis Example 6 | a-6 | 2,100 | - | - | X-10 | 100 |

### Preparation of Radiation-Sensitive Composition

Components other than the metal oxide (A) used for preparing radiation-sensitive compositions are shown below.

### (B) Solvent

B-1: 4-methyl-2-pentanol

### (C) Base Generator

C-1: 2-nitrobenzylcyclohexyl carbamate

### (D) Surfactant

D-1: nonionic acetylene group-containing surfactant ("Surfinol 465", available from Nissin Chemical Co., Ltd.)

### Example 1

A radiation-sensitive composition (J-1) of Example 1 was prepared by mixing 3.0 parts by mass of the metal oxide (A-1) and 97.0 parts by mass of the solvent (B-1), and filtering a thus obtained mixture through a membrane filter having a pore size of 0.2 µm.

### Examples 2 to 13 and Comparative Examples 1 to 6

Radiation-sensitive compositions (J-2) to (J-13) of Examples 2 to 13 and radiation-sensitive compositions (j-1) to (j-6) of Comparative Examples 1 to 6 were prepared by a similar operation to that of Example 1 except that the type and the content of each component were as shown in Table 2 below. It is to be noted that the denotation "-" in Table 2 below indicates that a corresponding component was not used.

### Evaluations

Evaluation of sensitivity was made by using each radiation-sensitive composition of Examples and Comparative Examples through forming a pattern in accordance with the following method. In addition, evaluations of etching resistance and a coating characteristic of the radiation-sensitive composition on a substrate were made according to the following method. The results of the evaluation are shown together in Table 2 below.

### Formation of Metal-Containing Film

After the radiation-sensitive composition (J-1) prepared in Example 1 described above was spin-coated on a silicon wafer in CLEAN TRACK ACT-8 available from Tokyo Electron Limited, PB was carried out under a condition of 80 °C for 60 sec to form a metal-containing film having an average thickness (averaged value of the film thickness at arbitrary nine points on the silicon wafer) of 50 nm. The radiation-sensitive compositions (J-2) to (J-13) and (j-1) to (i-6) were similarly applied to form the metal-containing film having an average thickness of 50 nm.

### Pattern Formation

The metal-containing film corresponding to each radiation-sensitive composition obtained as described above was subjected to patterning by irradiating with an electron beam using a simplified electron beam writer ("HL800D" available from Hitachi, Ltd., power: 50 KeV, electric current density: 5.0 ampere/cm²) such that a width of a line part and a width of a space part formed between neighboring line parts has a ratio of 1:1 (line-and-space pattern (1L 1S)). After the irradiation with the electron beam, in the CLEAN TRACK ACT-8, propylene glycol monomethyl ether acetate was used to carry out a development in accordance with a puddle procedure at 23 °C for 1 min, followed by drying, whereby the pattern was formed.

### Sensitivity

An exposure dose was decided, at which formation of a line-and-space pattern (1L IS) was enabled, the line-and-space pattern including a line part having a width of 150 nm and a space part having a width of 150 nm formed between neighboring line parts, and this exposure dose was defined as an optimum exposure dose, which was employed as an indicative of the sensitivity (µC/cm²).

### Etching Resistance

The substrate which had been provided with the metal-containing film obtained as described above was subjected to a treatment by using a plasma etching apparatus ("EXAM" available from SHINKO SEIKI CO., LTD.), under conditions involving O₂ of 100 sccm, at 100 W for 60 sec. An etching rate (nm/ sec) was calculated from average film thicknesses of before and after the treatment, and the oxygen-etching resistance was evaluated therefrom. The etching resistance was evaluated to be: "A" (very favorable) in the case of the etching rate being less than 4.5 (nm/min); "B" (favorable) in the case of the etching rate being no less than 4.5 (nm/min) and less than 5.0 (nm/min); and "C" (unfavorable) in the case of the etching rate being no less than 5.0 (nm/ sec).

### Coating Characteristic

The radiation-sensitive resin composition prepared as described above was applied onto the surface of an 8-inch silicon wafer by using a spin coater (Tokyo Electron Limited, "CLEAN TRACK ACT8"), and then subjected to PB at 80 °C for 60 sec. Thereafter, cooling was carried out at 23 °C for 30 sec to form a resist film having an average thickness of 50 nm. The coating characteristic was evaluated by visually observing the presence/absence of striation (radially running streaks from the center portion toward the peripheral portion) and repellency, to be: "favorable" in the case where these defects were found; and "unfavorable" in the case where these defects were not found.

**Table 2**

| | Radiation-sensitive composition | (A) Metal oxide | | (B) Solvent | | (C) Base generator | | (D) Surfactant | | Pattern formation | | Evaluation | | |
|---|---|---|---|---|---|---|---|---|---|---|---|---|---|---|
| | | Type | parts by mass | type | parts by mass | type | parts by mass | Type | parts by mass | Developer solution | Pattern tone | Sensitivity (µC/cm²) | Etching resistance | Coating characteristic |
| Example 1 | J-1 | A-1 | 3.0 | B-1 | 97.0 | - | - | - | - | PGMEA | negative | 30 | A | favorable |
| Example 2 | J-2 | A-2 | 3.0 | B-1 | 97.0 | - | - | - | - | PGMEA | negative | 33 | A | favorable |
| Example 3 | J-3 | A-3 | 3.0 | B-1 | 97.0 | - | - | - | - | PGMEA | negative | 18 | A | favorable |
| Example 4 | J-4 | A-4 | 3.0 | B-1 | 97.0 | - | - | - | - | PGMEA | negative | 18 | A | favorable |
| Example 5 | J-5 | A-5 | 3.0 | B-1 | 97.0 | - | - | - | - | PGMEA | negative | 25 | B | favorable |
| Example 6 | J-6 | A-6 | 3.0 | B-1 | 97.0 | - | - | - | - | PGMEA | negative | 28 | A | favorable |
| Example 7 | J-7 | A-7 | 3.0 | B-1 | 97.0 | - | - | - | - | PGMEA | negative | 22 | B | favorable |
| Example 8 | J-8 | A-1 | 2.9 | B-1 | 97.0 | C-1 | 0.090 | - | - | PGMEA | negative | 27 | A | favorable |
| Example 9 | J-9 | A-1 | 2.9 | B-1 | 97.0 | C-1 | 0.090 | D-1 | 0.001 | PGMEA | negative | 26 | A | favorable |
| Example 10 | J-10 | A-8 | 3.0 | B-1 | 97.0 | | | | | PGMEA | negative | 29 | A | favorable |
| Example 11 | J-11 | A-9 | 3.0 | B-1 | 97.0 | | | | | PGMEA | negative | 30 | A | favorable |
| Example 12 | J-12 | A-10 | 3.0 | B-1 | 97.0 | | | | | PGMEA | negative | 33 | A | favorable |
| Example 13 | J-13 | A-11 | 3.0 | B-1 | 97.0 | - | - | - | - | PGMEA | negative | 30 | A | favorable |
| Comparative Example 1 | j-1 | a-1 | 3.0 | B-1 | 97.0 | - | - | - | - | PGMEA | negative | 32 | C | favorable |
| Comparative Example 2 | j-2 | a-2 | 3.0 | B-1 | 97.0 | - | - | - | - | PGMEA | negative | 35 | C | favorable |
| Comparative Example 3 | j-3 | a-3 | 3.0 | B-1 | 97.0 | - | - | - | - | PGMEA | negative | (not resolved) | A | unfavorable (striation) |
| Comparative Example 4 | j-4 | a-4 | 3.0 | B-1 | 97.0 | - | - | - | - | PGMEA | negative | 53 | C | unfavorable(repellency) |
| Comparative Example 5 | j-5 | a-5 | 3.0 | B-1 | 97.0 | - | - | - | - | PGMEA | negative | 40 | C | favorable |
| Comparative Example 6 | j-6 | a-6 | 3.0 | B-1 | 97.0 | - | - | - | - | PGMEA | negative | (not resolved) | A | unfavorable (striation) |

As is seen from the results shown in Table 2 above, the radiation-sensitive compositions of Examples were superior in sensitivity and enabled a pattern superior in etching resistance to be formed, as compared with the radiation-sensitive compositions of Comparative Examples.

### [INDUSTRIAL APPLICABILITY]

The radiation-sensitive composition and the pattern-forming method of the embodiments of the present invention enable a pattern superior in etching resistance to be formed with superior sensitivity being achieved. Therefore, these can be suitably used in manufacture of semiconductor devices in which further progress of miniaturization is expected in the future.

## Claims

1. A radiation-sensitive composition which comprises:
a metal oxide comprising a first structural unit represented by formula (1), formula (2) or a combination thereof, and a second structural unit represented by formula (3); and
a solvent, 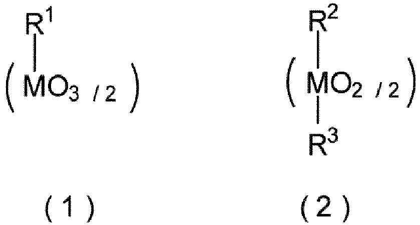 wherein,
in the formulae (1) and (2), Ms each independently represent germanium, tin or lead; and R¹, R² and R³ each independently represent a monovalent organic group having 1 to 40 carbon atoms which bonds to M via a carbon atom, and
(MO_{4/2}) (3)
in the formula (3), M represents germanium, tin or lead.

2. The radiation-sensitive composition according to claim 1, wherein a proportion of the first structural unit comprised with respect to total structural units constituting the metal oxide is no less than 50 mol%.

3. The radiation-sensitive composition according to claim 1 or 2, wherein R¹ in the formula (1) and R² in the formula (2) each represent a monovalent hydrocarbon group having 1 to 20 carbon atoms, wherein at least a part of hydrogen atoms thereof is substituted with a substituent that is an unsaturated bond-containing group, an electron attractive group or a combination thereof.

4. The radiation-sensitive composition according to any one of claims 1 to 3, which further comprises a radiation-sensitive base generator.

5. The radiation-sensitive composition according to any one of claims 1 to 4, wherein a content of the metal oxide in terms of solid content equivalent is no less than 50% by mass.

6. The radiation-sensitive composition according to any one of claims 1 to 5, wherein the solvent is an organic solvent.

7. A pattern-forming method comprising:
applying the radiation-sensitive composition according to any one of claims 1 to 6 directly or indirectly on a substrate to provide a film;
exposing the film; and
developing the film exposed.

8. The pattern-forming method according to claim 7, wherein a developer solution used in the developing comprises an organic solvent.

9. The pattern-forming method according to claim 7 or 8, wherein a radioactive ray used in the exposing is an extreme ultraviolet ray or an electron beam.
